# EUROPEAN PATENT APPLICATION

(11) **EP 2 133 926 A1**
(43) Date of publication of application: **16.12.2009**
(21) Application number: 08425415.0
(22) Date of filing: 11.06.2008
(51) Int. Cl.: H01L 31/042, H01L 31/05

(54) **Antitheft device for photovoltaic panels**

(71) Applicant: SAVIO S.p.A., 10050 Chiusa San Michele (IT)
(72) Inventor: Palazzetti, Mario, 10050 Chiusa San Michele (Torino) (IT); Balbo di Vinadio, Aimone, 10050 Chiusa San Michele (Torino) (IT)
(74) Representative: Marchitelli, Mauro

(57) **Abstract**

An antitheft device (10, 11) for photovoltaic panels (1) connected by means of a connection line (L) to a distribution substation, and comprises a first unit (11) associated to the distribution substation, and a plurality of second units (10) associated to the panels (1), in which the first unit (11) is designed to generate an activation code (4), and each of the second units (10) is designed to inhibit operation of the respective panel (1) in the absence of the activation code (4) for a pre-set period.

The first unit (11) comprises a code generator (4), which generates the activation code and sends it with a pre-set rate onto the connection line (L).

Each of the second units (10) comprises:
- a storage element (2b), designed to store within it a copy of the activation code;
- a counter (2a), designed to count the activation-code wait time;
- a logic unit (2c), designed to process the activation code present on the connection line (L) with the one stored in the storage element (2b), in which said logic unit (2c) is configured for resetting the counter element (2a) in the event of positive outcome of the decoding; and
- a switch (3), governed by the logic unit (2c), designed to deactivate operation of the panel (1) when the counter element (2a) reaches a pre-set configuration.

The second units (10) are integrated within the photovoltaic panels (1) so as to rule out any possibility of tampering or removal of the second units without causing damage to the photovoltaic panels.

## Description

The present invention relates in general to photovoltaic systems and in particular to an antitheft device for photovoltaic panels.

A photovoltaic panel, also referred to as photovoltaic module, is a particular type of solar panel that is able to generate electrical current when it is exposed to sunlight. This is also the main characteristic that distinguishes it from the more common thermal solar panel, which is used, instead, to produce hot water for sanitary purposes or to heat a building.

Photovoltaic technology enables direct conversion of the energy associated to solar radiation into electrical energy. This technology exploits the so-called photovoltaic effect, based upon the properties of some semiconductor materials, which, appropriately treated with insertion of a doping of other materials and interfaced in order to form junctions with different types of doping, are able to generate electricity once impinged upon by solar radiation. An example of semiconductor material that is frequently used to provide the photovoltaic cells comprised in the panels is represented by silicon.

In the last few years, photovoltaic technology has undergone a considerable expansion; in particular, it is very advantageous in remote areas, where said technology has always occupied a strategic role for the distributed generation of electrical energy. However, since in the majority of cases these are sites that are unprotected, this has implied exposure to a high risk of theft of the photovoltaic panels.

Given the high cost of photovoltaic panels, in order to counter the increasing phenomenon of thefts, ENEA (the Italian Agency for New Technologies, Energy, and the Environment) has developed an antitheft device for photovoltaic panels, called "PV-Guardian". This is an antitheft device integrated in the photovoltaic panel, the function of which is to deactivate the panel electrically in the case where it were to be removed from the original position of installation. The PV-Guardian is essentially based upon the use of a GPS (Global Positioning System) receiver similar to the one used in current satellite navigators. During installation of a photovoltaic panel equipped with this antitheft device, the user executes procedures of configuration that enable setting of the terrestrial geographical co-ordinates (latitude and longitude measured by the GPS receiver) for the installation site of the panel. Thanks to the GPS technology integrated in the antitheft device, a possible displacement of the photovoltaic panel means that the new geographical co-ordinates detected will differ from those of the position configured in the installation stage. In this condition, the antitheft device deactivates the supply of the current by the photovoltaic panel and renders the removed panel unusable unless it is relocated once again in its original installation site.

However, said antitheft device suffers from the problem that it functions properly only in the areas in which there is a certain number of satellites in view. Furthermore, the use of a GPS receiver for each panel increases the cost considerably.

With the exception of the aforesaid PV-Guardian device at the moment there is not yet available an antitheft device that is inexpensive and suitable for preventing operation of a photovoltaic panel in the event of theft.

The object of the present invention is to provide an antitheft device that is able to inhibit totally operation of the photovoltaic panel in the event of theft and that will be less costly and simpler to produce than the antitheft devices of a known type.

According to the present invention, said object is achieved by an antitheft device having the characteristics forming the subject of Claim 1.

The antitheft device according to the invention can be applied to any photovoltaic panel, for example during its fabrication (lamination), and this excludes any possibility of tampering or removal of the antitheft device, without causing irreparable damage to the photovoltaic panel.

Further characteristics and advantages of the invention will emerge from the ensuing description with reference to the annexed drawings, which are provided purely by way of non-limiting example and in which:
- Figure 1 shows an example of a photovoltaic system equipped with an antitheft device according to the invention;
- Figure 2 shows an example of positioning of the antitheft device within a photovoltaic panel;
- Figure 3 shows in detail the connection of the antitheft device between the cells that make up the photovoltaic panel; and
- Figure 4 is a cross-sectional view of a portion of panel.

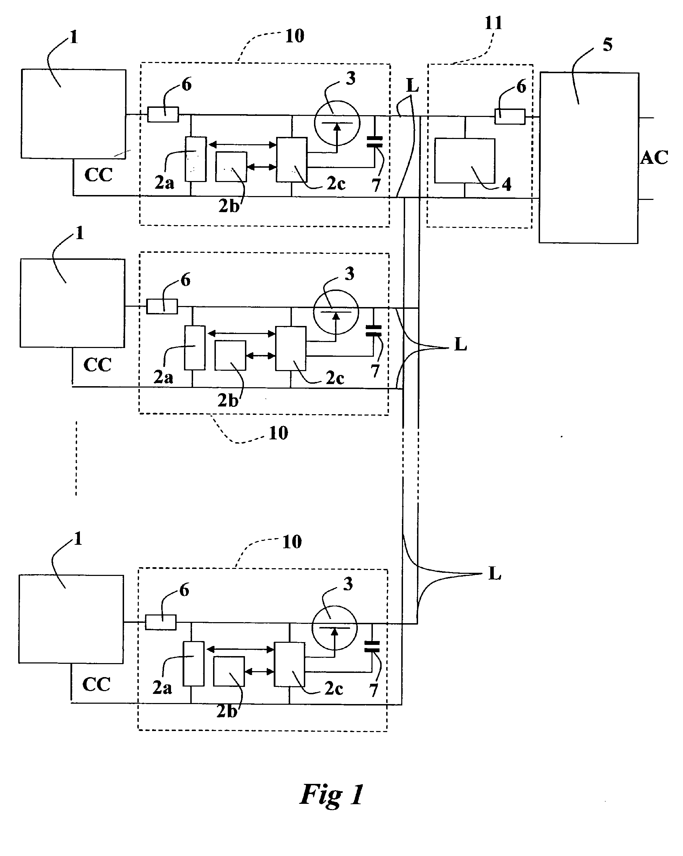

With reference to Figure 1, a plurality of photovoltaic panels 1 is connected in parallel to the two conductors of a connection line designated as a whole by L to form a photovoltaic system.

The energy produced by a photovoltaic panel 1 is in the form of direct current CC. To convert the direct current into alternating current AC it is necessary to introduce into the system an inverter device, designated by the reference number 5 in Figure 1. In all the cases in which direct current CC is usable directly, the inverter is not present. In the following, however, we shall continue to refer to the inverter, indicating in this way a circuit site in which the unit 4 will be inserted.

The antitheft device according to the present invention comprises a first unit 11 associated to the distribution substation on the side of the system, and a plurality of second units 10 associated to the panels 1.

With reference to Figure 1, the first unit 11 comprises a code generator 4, which generates an activation code and, with a pre-set rate, sends it onto the conductors of the connection line L, and an inductance 6, which is used to prevent the high-frequency signal generated by the code generator 4 from being propagated downstream to the inverter 5 and upstream to the panels.

Once again with reference to Figure 1, an example of embodiment of the second unit 10 comprises a counter 2a, a storage element 2b, a logic unit 2c, and a switch 3. There are moreover present an inductance 6, which is used to prevent the signal generated by the code generator 4 from being propagated to the photovoltaic panel 1, and a capacitor 7 that is used to bring the high-frequency signal generated by the code generator 4 to the logic unit 2c.

The storage element 2b stores within it a copy of the activation code for decoding with the code that arrives on the connection line L. The storage element 2b is preferably a read-only memory (ROM), and the activation code can be written and personalized by the user in the installation stage by burning the metallizations with a laser beam.

The counter 2a is used for scanning the code-activation wait time.

The code generator 4 sends the activation code on the line L at periodic intervals. The logic unit 2c processes the code stored with that of activation present on the connection line L to activate the switch 3. The logic unit 2c is configured for resetting the counter 2a in the event of positive outcome of the decoding.

In the event of negative outcome of the decoding, the counter 2b is not reset by the logic unit 2c and continues to count until it reaches a pre-set configuration. This situation arises when the panel is removed from the system and does not receive the activation code within the wait time set. At this point, the logic unit 2c governs opening of the switch 3 to deactivate the operation of the respective panel 1. The switch 3 may for example be a field-effect transistor (FET).

Then, each second unit 10 inhibits operation of the respective panel 1 in the absence of the activation code 4 for a pre-set period.

The activation code may be far from complex but safe so as to speed up and render inexpensive the step of decoding performed by the logic unit 2c. The activation code is not always present on the connection line L, but is sent onto it by the code generator 4 with a pre-set rate. In this way, it becomes difficult to intercept it, read it, and simulate it. Furthermore, cryptography schemes may be used for encoding the code and rendering it more robust.

The second units 10, which together with the first unit 11 perform the function of antitheft device, are associated to the panels. The second units 10 can be external or else, for greater safety, can be integrated within the photovoltaic panels themselves.

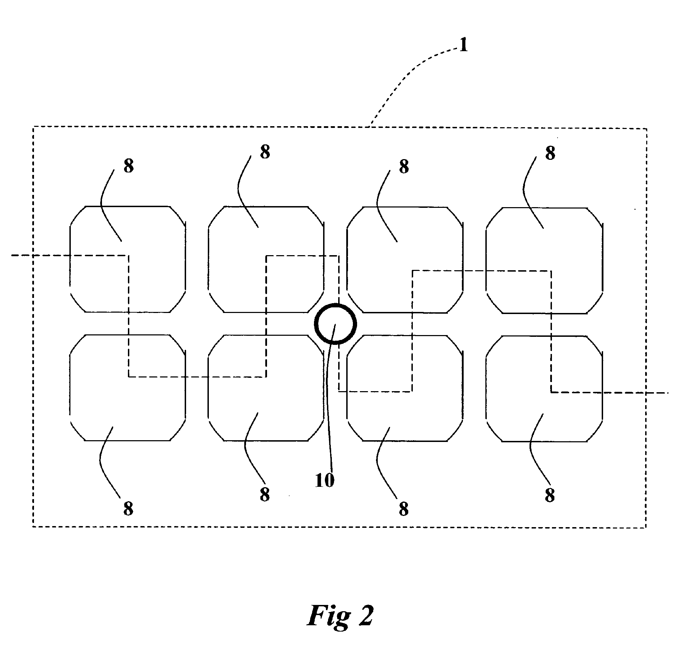

Figure 2 shows, for example, a second unit 10 integrated within a photovoltaic panel 1 so as to rule out any possibility of tampering or removal thereof, without damaging the panel. This characteristic can in any case be obtained by positioning the second unit 10 in such a way that the panel is damaged if it is tampered with.

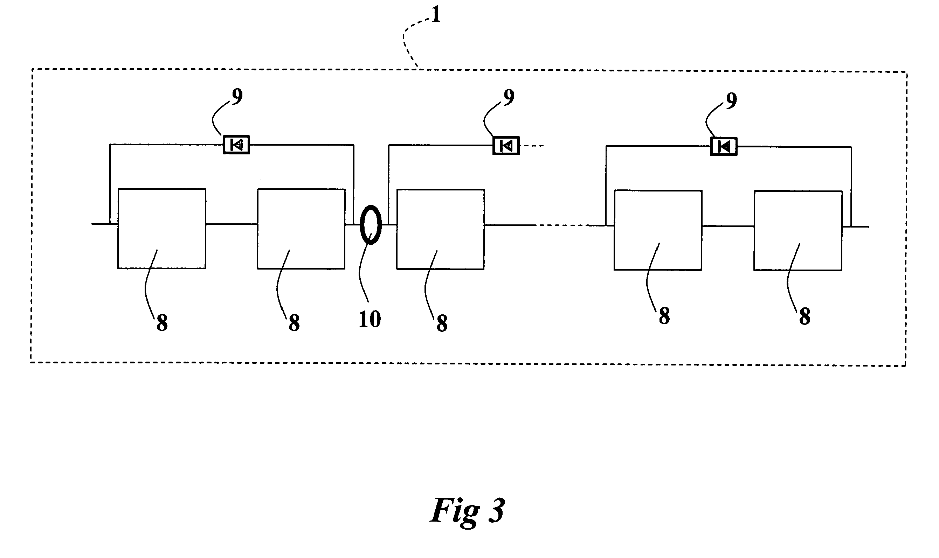

In Figures 2 and 3, it may be noted that each photovoltaic panel 1 comprises a plurality of photovoltaic cells designated by the reference 8 connected to one another in series.

Each photovoltaic cell 8 is built starting from a cylindrical bar of silicon with circular cross section. A thin plate is made from the bar, which is then cut so as to form a square cell with rounded edges. This is used to optimize the setting of the cells within a panel so as to have the largest surface possible of the panel coated with cells.

With particular reference to Figure 3, in order to guarantee the continuity of the electrical connection of the entire photovoltaic panel 1, by-pass diodes 9 are provided, connected in parallel to each pair of photovoltaic cells 8. The purpose of this is to prevent phenomena of obscuration due to the presence of leaves, insects or objects that obscure a photovoltaic cell 8, rendering it in effect an open circuit.

In the examples illustrated in Figures 2 and 3, the second unit 10 is positioned so as not to be by-passed by the diodes 9.

In particular, the second units 10 behaves as a whole like a short circuit when the switch 3 is closed, i.e., when the panel is connected to the system and receives the activation code with a pre-set rate, and like an open circuit when the panel is disconnected from the system. This behaviour is very advantageous in the stage of installation of the panels because it guarantees the safety of the installers. The antitheft device hence functions also as protection device for the person responsible for installation during installation of the panels 1.

The antitheft device according to the present invention is supplied by the photovoltaic panels that make up the system. In the absence of sunlight it does not function. When the panels are illuminated by the sun, the switch 3 is closed and the counter 2b starts its count. When the logic unit 2c receives the activation code on the connection line L, it decodes it and, in the event of positive outcome, resets the counter 2a, so producing the first activation.

In particular, the second unit 10 behaves as an enabling switch that authorizes the respective photovoltaic panel 1 to produce current.

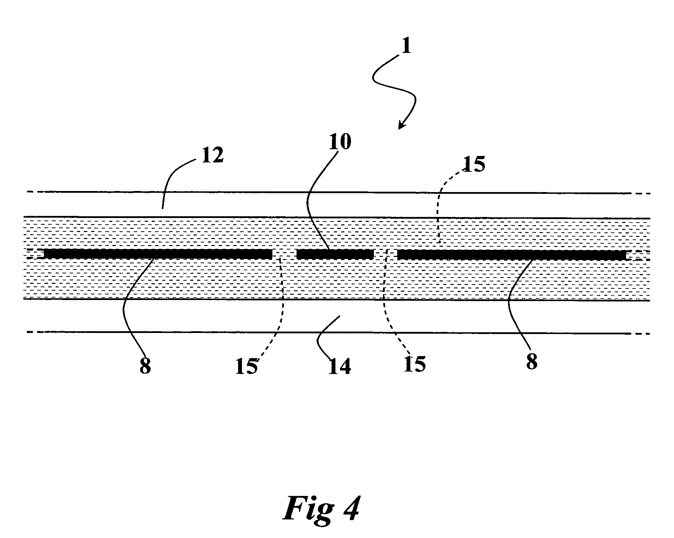

With particular reference to Figure 4, a photovoltaic panel 1 has a sandwich structure with a bottom layer 14 of sheet metal or glass, an intermediate layer 15 of EVA (ethylvinyl acetate) resin that has the function of encapsulation the cells 8 and adhesion between the cells 8 and the top layer of glass 12. The second unit 10 could be, for example, embedded in the intermediate EVA layer.

Since the first unit 11, which is usually well protected in a masonry structure or in the distribution substation, could be stolen together with the panels 1, it is necessary for it to be in turn protected with another type of antitheft device, for example the one mentioned previously (PV-Guardian, ENEA), or else there may be provided a system which, if it is removed, can cause destruction of the memory that contains the activation code of the unit 4.

## Claims

1. An antitheft device (10,11) for photovoltaic panels (1) connected by means of a connection line (L) to a distribution substation (5), comprising a first unit (11) associated to the distribution substation (5), and a plurality of second units (10) associated to the panels (1), in which said first unit (11) is designed to generate an activation code (4), and each of said second units (10) is designed to inhibit operation of the respective panel (1) in the absence of said activation code (4) for a pre-set period.

2. The antitheft device according to Claim 1, **characterized in that** said first unit (11) comprises a code generator (4), which generates the activation code and sends it with a pre-set rate onto the connection line (L).

3. The antitheft device according to Claim 2, **characterized in that** each of said second units (10) comprises:
- a storage element (2b), designed to store within it a copy of the activation code;
- a counter (2a), designed to count the activation-code wait time;
- a logic unit (2c), designed to compare the activation code present on the connection line (L) with the one stored in the storage element (2b), in which said logic unit (2c) is configured for resetting the counter element (2a) in the event of positive outcome of the decoding; and
- a switch (3), governed by the logic unit (2c), designed to deactivate operation of the panel (1) when the counter element (2a) reaches a pre-set configuration.

4. The antitheft device according to Claim 3, **characterized in that** said storage element (2b) is a read-only memory (ROM).

5. The antitheft device according to Claim 3 or Claim 4, **characterized in that** said switch (3) is a field-effect transistor (FET).

6. The antitheft device according to any one of Claims 3 to 5, **characterized in that** said second units (10) are arranged so as to rule out any possibility of tampering or removal of the panels (1) without causing any damage thereto.

7. The antitheft device according to Claim 6, **characterized in that** each photovoltaic panel (1) comprises a plurality of photovoltaic cells (8) connected to one another in series and **in that** said second unit (10) is set between two photovoltaic cells (8).

8. The antitheft device according to Claim 7, **characterized in that** each photovoltaic panel (1) comprises a plurality of by-pass diodes (9) arranged in parallel to a plurality of photovoltaic cells (8) and **in that** each second unit (10) is positioned so as not to be by-passed by the by-pass diodes (9).

9. The antitheft device according to any one of the preceding Claims, **characterized in that** each second unit (10) of said plurality is supplied by the respective photovoltaic panel.

10. The antitheft device according to any one of the preceding claims, **characterized in that** said antitheft device functions also as protection device for the persons responsible for installation during the installation of the panels (1).

11. The antitheft device according to any one of the preceding Claims 2 to 10, **characterized in that** said first unit (11) comprises a second antitheft device designed to protect the code generator (4).
